# EUROPEAN PATENT APPLICATION

(11) **EP 4 794 503 A1**
(43) Date of publication of application: **19.08.2026**
(21) Application number: 25157651.8
(22) Date of filing: 13.02.2025
(51) Int. Cl.: H10K 85/30, H10K 85/60, H10K 101/10, H10K 101/30

(54) **ORGANIC LIGHT-EMITTING DIODE AND METHOD TO PRODUCE SUCH AN ORGANIC LIGHT-EMITTING DIODE**

(71) Applicant: CREDOXYS GmbH, 01187 Dresden (DE)
(72) Inventor: STOLZ, Julia, 01187 Dresden (DE); SAMIGULLINA, Dinara, 01187 Dresden (DE)

(57) **Abstract**

The present invention relates to an organic light-emitting diode (OLED) comprising an anode layer, a cathode layer, and several organic layers arranged between the anode layer and the cathode layer, including at least a blue phosphorescent emissive layer and at least one deep-HOMO p-doped semiconductor layer, wherein the blue phosphorescent emission layer comprises at least one blue phosphorescent emitter material and an emitter host material. In addition, the OLED comprises a deep-HOMO p-doped semiconductor layer with a deep-LUMO p-dopant which is an organometallic complex comprising Ce(IV). Advantageously, the operation voltage and the power conversion efficiency can be improved.

Further, the present invention relates to a method to produce such an OLED.

## Description

The present invention relates to an organic light-emitting diode (OLED) comprising an anode layer, a cathode layer, and several organic layers arranged between the anode layer and the cathode layer, including at least a blue phosphorescent emissive layer and at least one deep-HOMO p-doped semiconductor layer, wherein the blue phosphorescent emission layer comprises at least one blue phosphorescent emitter material and an emissive host material. Further, the present invention relates to a method to produce such an OLED.

### BACKGROUND OF THE INVENTION

Organic electronics deals with the development, characterization, and application of new materials, both based on small organic molecules and polymers with certain desired electronic properties for the fabrication of electronic components. These include, for example, organic field-effect transistors (OFETs), such as organic thin-film transistors (OTFTs), organic electroluminescent devices, such as organic light-emitting diodes (OLEDs), organic solar cells (OSCs), e.g. exciton solar cells, dye-sensitized solar cells (DSSCs), or perovskite solar cells; electrophotography, e.g., photoconductive materials in organic photoconductors (OPCs); organic optical detectors; organic photoreceptors; light-emitting electrochemical cells (LECs); and organic laser diodes.

It is known that semiconductor matrix materials, in particular organic semiconductor materials, can be strongly influenced in terms of their electrical conductivity by redox doping. Such semiconductor matrix materials can be built either from compounds with electron donor properties (p-type conductors) or from compounds with electron acceptor properties (n-type conductors). Unlike inorganic semiconductors, organic semiconductors have a very low intrinsic charge carrier density. To achieve good semiconductor properties, organic semiconductor matrix materials can be doped, i.e. molecules are introduced into the intrinsic semiconductor matrix material. For n-doping, strong electron donors (n-dopants) are used to transfer an electron to the LUMO (lowest unoccupied molecular orbital) of the semiconductor matrix material (n-doping), resulting in a free electron on the matrix material (SOMO - singly occupied molecular orbital). For p-doping, strong electron acceptors (p-dopants) are used to remove an electron from the HOMO (highest occupied molecular orbital) of the semiconductor matrix material (p-doping), leaving a hole. In other words, for effective p-doping, the LUMO of the dopant must be below the HOMO energy of the matrix material. The p-dopant acts as an acceptor for an electron, leaving a moving hole (SOMO) in the matrix.

The conductivity of the semiconductor matrix material (hole transport material) is changed to a greater or lesser extent depending on the number and mobility of the holes.

Known p-dopants for electron donor materials are electron acceptors such as tetracyanoquinone methane (TCNQ), 2,3,5,6-tetrafluorotetracyano-1,4-benzoquinone methane (F4TCNQ), trinaphthylenes (HATNA), metal oxides such as MoO₃ or WO₃, or radialenes as described in EP 2180029 or other withdrawing groups as described in EP3176844B1.

Further p-dopants are disclosed in WO 2021/048044 A1 and WO 2022/189431 A1, which relate to cerium (IV) diketonate complexes as electron acceptors, specifically to be used as p-dopants in organic electronic components.

One type of organic electronic devices are organic light-emitting diodes (OLEDs). The OLED technology is highly suited to be used in the production of lighting modules and displays - as OLEDs are flexible, lightweight and have excellent light-emitting properties, such as high-power efficiency and tunable color. OLEDs consist of several layers. In particular, an OLED comprises an anode, a cathode, an emitter material, and charge carrier transport layers such as an electron transport layer and a hole transport layer.

The composition and arrangement of the layers of an OLED is critical for its overall performance. A poorly optimized arrangement of materials can lead to low brightness, and rapid degradation. In particular, the combination of emitter materials and hole transport materials plays a crucial role in determining the efficiency of hole injection, hole transport, and light emission, as well as the operational lifetime. Therefore, achieving a well-balanced and optimized structure is essential for enhancing the performance and longevity of OLED devices.

The use of blue phosphorescent emitter materials is particularly favorable to obtain OLEDs with high quantum and current efficiencies. However, an optimized arrangement of emitter and hole-transport materials is particularly challenging for OLEDs with blue phosphorescent emitters, leading to high operating voltage, low power efficiency, reduced operational lifetime, and poor color purity.

Accordingly, there is an ongoing demand for OLEDs that have improved properties, in particular with regard to their operating voltage and efficiency.

Therefore, it is an object of the invention to provide OLEDs, which have improved properties.

### SUMMARY OF THE INVENTION

A first object of the invention relates to an organic light-emitting diode comprising:
- an anode layer, a cathode layer, and several organic layers arranged between the anode layer and the cathode layer, including at least a blue phosphorescent emissive layer and at least one deep-HOMO p-doped semiconductor layer,
- Wherein the blue phosphorescent emissive layer comprises at least one blue phosphorescent emitter material and an emitter host material,
- wherein the deep HOMO p-doped semiconductor layer is arranged between the anode layer and the blue phosphorescent emissive layer, wherein the deep HOMO p-doped semiconductor layer comprises a deep-HOMO hole transport material and a deep-LUMO p-dopant,

wherein the HOMO of the deep-HOMO hole transport material is in the range between - 5.0 eV and -6.0 eV when determined by DFT calculations, and
wherein the deep-LUMO p-dopant is an organometallic complex comprising Ce(IV) and wherein the LUMO of the deep LUMO p-dopant is in the range between -4.8 eV
and -5.8 eV when determined by DFT calculations.

A further object of the invention is a method to produce an organic light-emitting diode according to the invention, comprising at least one of the following steps:
(a) Simultaneous evaporation of the hole transport material and the deep LUMO p-dopant,
(b) Evaporation of a pre-mixed material containing the hole transport material and the deep LUMO p-dopant from one single source,
(c) Sequential deposition of the hole transport material and the deep-LUMO p-dopant,
(d) Doping of a hole transport material layer by a solution of at least one deep-LUMO p-dopant followed by evaporation of the solvent by thermal treatment,
(e) Surface doping of a layer of a deep-HOMO hole transport material by a layer of at least one deep-LUMO p-dopant, in particular a compound of general formula (I) or a compound of general formula (II) as described herein, applied to one or both surfaces of the layer of a deep-HOMO hole transport material,
(f) Preparing a solution of a deep-HOMO hole transport material and at least one deep-LUMO p-dopant, in particular a compound of general formula (I) or a compound of general formula (II) as described herein, and forming a film from the solution.

### DESCRIPTION OF THE INVENTION

The invention has the following advantages:
- The OLEDs according to the invention comprise cerium (IV) complexes that are advantageously suitable as p-dopants for hole transport materials with deep HOMO levels. Accordingly, hole injection barriers between the anode and the emissive layer can be reduced and, therefore, OLEDs according to the invention have advantageously lower operating voltages and higher power efficiencies.
- The use of deep-HOMO hole transport materials in the deep-HOMO p-doped semiconductor layer, which can be a hole injection layer and/or a hole transport layer allows for the application of emitter host material with even deeper HOMO levels leading to a better confinement of excitons and an improvement of the efficiency of the blue emission.
- The reduction of hole-injection barriers in OLEDs according to the invention leads to a longer operational lifetime.
- The cerium (IV) complexes applied for the invention show improved thermostability of the doped layers compared to the prior art. Therefore, the OLEDs show an improved thermostability.
- The cerium (IV) complexes according to the invention exhibit only a low absorption of the doped layer. Thus, parasitic absorption and emission can be reduced or even prevented. Accordingly, the efficiency of the OLED according to the invention is improved.
- The cerium (IV) complexes according to the invention have typically less than 10% source residue while being evaporated using high evaporation rates. Accordingly, the manufacturing costs can be advantageously reduced.
- The cerium (IV) complexes according to the invention are stable for several days at high temperatures as used during evaporation in mass production. As a result, the production process of OLEDs according to the invention becomes more cost-effective and scalable, ultimately supporting high-yield manufacturing with consistent quality across large batches of OLEDs.
- The OLEDs according to the invention have only low manufacturing costs.

Surprisingly, it has been found that deep-LUMO p-dopants, in particular cerium(IV) complexes with anionic ketonate-based ligands such like compounds of general formula (I) or compounds of general formula (II) as described herein, are particular suitable for an application in phosphorescent blue organic light-emitting diodes, when combined with deep-HOMO hole-transport materials.

Surprisingly, it has been found that OLEDs according to the invention comprising blue phosphorescent emitter materials and a deep HOMO p-doped semiconductor layer comprising a deep-HOMO hole transport material doped by a deep-LUMO p-dopant, which can be a cerium compound preferably according to general formula (I) or according to general formula (II), show advantageous properties such as:
- Lower hole injection barriers and therefore a reduced driving voltage and higher power efficiency.
- Suitability for mass production, as the p-dopants according to the invention have advantageous evaporation properties.

These advantages particularly apply in combination with a deep-HOMO hole transport material having a HOMO in the range between -5.0 eV and -6.0 eV when determined by DFT calculations, in particular a deep-HOMO hole transport material with a HOMO at least as deep as N,N'-((9H-fluorene-9,9-diyl)bis(4,1-phenylene))bis(N-([1,1'-biphenyl]-4-yl)-[1,1'-biphenyl]-4-amine) (BPAPF) when measured with the same method. The deep-HOMO hole transport material can be chosen for example from 4,4',4-Tris(carbazol-9-yl)triphenylamine (TCTA), or N,N'-((9H-fluorene-9,9-diyl)bis(4,1-phenylene))bis(N-([1,1'-biphenyl]-4-yl)-[1,1'-biphenyl]-4-amine) (BPAPF).

The terms "cerium compound" and "cerium complex" are used synonymously and can be defined by general formula (I) or by general formula (II). The ligands in the absence of the metal atom (cerium atom), are preferably defined by formula (I.b) or formula (Il.b).

In the context of the present specification the term "compound of the general formula (I)" means a compound that corresponds to the formula (I) as defined herein. An electronic component which comprises a compound of the general formula (I) may comprise each compound which is included in one of the preferred embodiments of the compounds as described herein. This also applies to the term "compound of the formula (I)".

In the context of the present specification the term "compound of the general formula (II)" means a compound that corresponds to the formula (II) as defined herein. An electronic component which comprises a compound of the general formula (II) may comprise each compound which is included in one of the preferred embodiments of the compounds as described herein. This also applies to the term "compound of the formula (II)".

In the context of the invention, a bidentate ligand (also called didentate) is a ligand, which binds with two atoms to the metal atom (cerium atom), i.e. the ligand binds to the metal atom (cerium atom) with two atoms.

In the context of the invention, a bis-bidentate ligand is a ligand, which binds with two atoms to the first of two central metal atoms (cerium atoms) and it binds with two different atoms to the second of two central metal atoms (cerium atoms).

In the context of the invention, formula (I.b) represents an exemplary mesomeric frontier structure to which the ligands L are not restricted. Other mesomeric structures are possible.

In the context of the invention, formula (II.b) represents an exemplary mesomeric structure to which the ligands L are not restricted. Other mesomeric structures are possible.

In the context of the invention, the prefix Cₙ-Cₘ indicates the number of carbon atoms that a molecule or residue designated thereby may contain.

In the context of the invention, the expression C₁-C₆-alkyl refers to unbranched or branched saturated hydrocarbon groups having 1 to 6 carbon atoms. C₁-C₆-alkyl are e.g. methyl, ethyl, propyl, 1-methylethyl, butyl, 1-methylpropyl, 2-methylpropyl, 1,1-dimethylethyl, pentyl, 1-methylbutyl, 2-methylbutyl, 3-methylbutyl, 2,2-dimethylpropyl, 1-ethylpropyl, hexyl, 1,1-dimethylpropyl, 1,2-dimethylpropyl, 1-methylpentyl, 2-methylpentyl, 3-methylpentyl, 4-methylpentyl, 1,1-dimethylbutyl, 1,2-dimethylbutyl, 1,3-dimethylbutyl, 2,2-dimethylbutyl, 2,3-dimethylbutyl, 3,3-dimethylbutyl, 1-ethylbutyl, 2-ethylbutyl, 1,1,2-trimethylpropyl, 1,2,2-trimethylpropyl, 1-ethyl-1-methylpropyl or 1-ethyl-2-methylpropyl. C₁-C₄-alkyl refers, e.g. to methyl, ethyl, propyl, 1-methylethyl, butyl, 1-methylpropyl, 2-methylpropyl or 1,1-dimethylethyl.

In the context of the invention the expression C₁-C₆-alkoxy refers to an unbranched or branched saturated C₁-C₆-alkyl group as defined above, which is bound via an oxygen atom. Alkoxy radicals with 1 to 4 carbon atoms are preferred, particularly preferred are 1 or 2 carbon atoms. C₁-C₂-alkoxy is methoxy or ethoxy. C₁-C₄-alkoxy is e.g. methoxy, ethoxy, n-propoxy, 1-methylethoxy (isopropoxy), butoxy, 1-methylpropoxy (sec-butoxy), 2-methylpropoxy (isobutoxy) or 1,1-dimethylethoxy (tert-butoxy). C₁-C₆-alkoxy comprises the meanings given for C₁-C₄-alkoxy and additionally e.g. pentoxy, 1 methylbutoxy, 2-methylbutoxy, 3-methylbutoxy, 1,1-dimethylpropoxy, 1,2-dimethylpropoxy, 2,2-dimethylpropoxy, 1-ethylpropoxy, hexyloxy, 1-methylpentoxy, 2-methylpentoxy, 3-methylpentoxy, 4-methylpentoxy, 1,1-dimethylbutoxy, 1,2-dimethylbutoxy, 1,3-dimethylbutoxy, 2,2-dimethylbutoxy, 2,3-dimethylbutoxy and 3,3-dimethylbutoxy.

In the context of the invention the expression C₁-C₆-alkylsulfanyl refers to an unbranched or branched saturated C₁-C₆-alkyl group as defined above, which is bound via a sulfur atom. Alkylsulfanyl radicals with 1 to 4 carbon atoms are preferred, particularly preferred are 1 or 2 carbon atoms. C₁-C₂-alkylsulfanyl is methylsulfanyl or ethylsulfanyl. C₁-C₄-alkylsulfanyl is e.g. methylsulfanyl, ethylsulfanyl, n-propylsulfanyl, 1-methylethylsulfanyl (isopropylsulfanyl), butylsulfanyl, 1-methylpropylsulfanyl (sec-butylsulfanyl), 2-methylpropylsulfanyl (isobutylsulfanyl) or 1,1-dimethylethylsulfanyl (tert-butylsulfanyl). C₁-C₆-alkylthio comprises the meanings given for C₁-C₄-alkylsulfanyl and additionally also, e.g., pentylsulfanyl, 1-methylbutylsulfanyl, 2-methylbutylsulfanyl, 3-methylbutylsulfanyl, 1,1-dimethylpropylsulfanyl, 1,2-dimethylpropylsulfanyl, 2,2-dimethylpropylsulfanyl, 1-ethylpropylsulfanyl, hexylsulfanyl, 1-methylpentylsulfanyl, 2-methylpentylsulfanyl, 3-methylpentylsulfanyl, 4-methylpentylsulfanyl, 1,1-dimethylbutylsulfanyl, 1,2-dimethylbutylsulfanyl, 1,3-dimethylbutylsulfanyl, 2,2-dimethylbutylsulfanyl, 2,3-dimethylbutylsulfanyl, 3,3-dimethylbutylsulfanyl, 1-ethylbutylsulfanyl, 2-ethylbutylsulfanyl, 1,1,2-trimethylpropylsulfanyl, 1,2,2-trimethylpropylsulfanyl, 1-ethyl-1-methylpropylsulfanyl or 1-ethyl-2-methylpropylsulfanyl.

In the context of the invention the expressions haloalkyl, haloalkoxy and haloalkylsulfanyl refer to partially or fully halogenated alkyl, alkoxy or alkylsulfanyl. In other words, one or more hydrogen atoms, for example 1, 2, 3, 4 or 5 hydrogen atoms bonded to one or more carbon atoms of alkyl, alkoxy or alkylsulfanyl are replaced by a halogen atom, in particular by fluorine or chlorine.

The expression "halogen" denotes in each case fluorine, chlorine, bromine or iodine.

The expression "CN" denotes the cyano group (-C≡N).

The expression "aryl" comprises in the context of the invention mono- or polynuclear aromatic hydrocarbon radicals with usually 6 to 14, especially preferably 6 to 10 carbon atoms. Examples of aryl are especially phenyl, naphthyl, indenyl, fluorenyl, anthracenyl, phenanthrenyl, naphthacenyl, chrysenyl, pyrenyl, etc. and especially phenyl or naphthyl.

The expression "hetaryl" comprises in the context of the invention mononuclear aromatic hydrocarbon radicals with 4 to 5 carbon atoms, wherein 1, 2 or 3 carbon atoms have been replaced by 1, 2 or 3 nitrogen atoms as ring members. The hetaryl group may be attached to the remainder of the molecule via a ring carbon or via a ring nitrogen. Examples of 5- or 6-membered aromatic heterocyclic rings (also called heteroaromatic rings or hetaryl) are 2-pyrrolyl, 3-pyrrolyl, 3-pyrazolyl, 4-pyrazolyl, 5-pyrazolyl, 2-imidazolyl, 4-imidazolyl, 1,3,4-triazol-2-yl, 2-pyridinyl, 3-pyridinyl, 4-pyridinyl, 3-pyridazinyl, 4-pyridazinyl, 2-pyrimidinyl, 4-pyrimidinyl, 5-pyrimidinyl and 2-pyrazinyl.

In the context of the invention the term "C₅-C₇-cycloalkyl" as used herein refers to a monocyclic membered saturated cycloaliphatic radicals, e.g. cyclopentyl, cyclohex- yl, cycloheptyl. The term C₅-C₇-halocycloalkyl as used herein, which is also expressed as "cycloalkyl which is partially or fully halogenated", refers C₅-C₇-cycloalkyl as mentioned above, in which some or all of the hydrogen atoms are replaced by halogen atoms as mentioned above, in particular fluorine.

In the context of the present specification the term "electron donor" means a compound with electron donor properties which is an element or a chemical compound which transfers an electron to another compound including the possible formation of a charge transfer complex. In the context of this specification an electron donor is a semiconductor material, in particular a semiconductor matrix material, which may be used as a hole transport material. In the context of this specification, a semiconductor material, in particular a hole transport material, may form a p-doped semiconductor layer, if combined with a compound suitable for an application as p-dopant.

In the context of the present specification the term "hole transport material" means a semiconductor matrix material.

In the context of the present specification a hole transport layer comprises a hole transport material and may comprise a p-dopant; furthermore, a hole transport layer may consist of a hole transport material only.

In the context of the present specification a hole injection layer comprises a hole transport material and a p-dopant; furthermore, a hole injection layer may consist of a p-dopant only.

In the context of the present specification, "triarylamine based compound" means a compound in which at least one nitrogen atom is bonded to three aryl groups via three covalent bonds, i.e. there are three covalent bonds, each of which bonds the nitrogen atom to at least one aryl group.

In the context of the present specification, a "carbazole based compound" means a compound in which one nitrogen atom of the carbazole group is bonded to one aryl group via a covalent bond.

In the context of the invention, "HOMO" or "HOMO level" mean the energy of the highest occupied molecular orbital of the respective molecule.

In combination with a compound suitable for an application as p-dopant, the hole transport material and the compound suitable for an application as p-dopant may form a hole transport layer and/or a p-doped semiconductor layer and/or a hole injection layer. In the context of the invention, a p-doped semiconductor layer, in particular a hole transport layer and/ or a hole injection layer, may comprise a hole transport material or a p-doped semiconductor layer, in particular a hole transport layer, may comprise a hole transport material and a p-dopant; furthermore, a hole transport layer may consist of a hole transport material only. In general, a semiconductor matrix material combined with a dopant or with a compound suitable as a dopant is a doped semiconductor.

In the context of the invention, the term "blue phosphorescent emitter" means an organometallic complex characterized by the emission of triplet exciton states (phosphorescent light). Preferably it means a compound comprising a transition metal, such as iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)).

In the context of the present specification the term "emissive layer" refers to the light-emitting layer. The term "blue phosphorescent emissive layer" refers to an emissive layer that comprises at least one blue phosphorescent emitter. It may also comprise further emitter materials, e.g., blue fluorescent emitters, in particular blue emitters showing thermally activated delayed fluorescence, or phosphorescent emitters of other colors, in particular to generate white light.

### Deep LUMO p-dopants

In the context of the invention, the term "deep-LUMO p-dopant" refers to an organometallic complex comprising cerium(IV), wherein the LUMO of the deep LUMO p-dopant is in the range between -4.8 eV and -5.8 eV when determined by DFT calculations.

As an option, deep-LUMO p-dopants refers to an organometallic complex comprising cerium(IV), wherein the LUMO of the deep LUMO p-dopant is at least as deep as the LUMO of Tetrakis[1-[3,5-bis(trifluoromethyl)phenyl]-4,4,4-trifluoro-1,3-butanedionato-κO1,κO3]cerium if measured with the same method.

### Cerium-Compounds of formula (I)

In one embodiment of an OLED the deep LUMO p-dopant is a compound of the general formula (I)

[Ce⁴⁺][(L_{I})₄]⁴⁻ (I),

wherein L_{I} is independently of each other a ligand with at least five carbon atoms.

Preferred are OLEDs comprising compounds of general formula (I) wherein all ligands L_{I} have the same meaning.

Preferably, the deep LUMO **p-dopant** is a compound according to formula (I)

Ce⁴⁺(L_{IA}L_{IB}L_{IC}L_{ID})⁴⁻ (I.a)

Or the mixtures thereof, wherein L_{IA;} L_{IB;} L_{IC;} and L_{ID} are independently from each other selected from a bidentate ligand having the general formula (I.b) 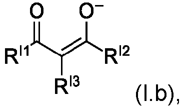
wherein
   - R^{I1}, R^{I2}: independently from each other represent CN, C₁-C₆-alkyl, C₁-C₆-haloalkyl, C₁-C₆-alkoxy, C₁-C₆-haloalkoxy, C₁-C₆-alkylsulfanyl, C₁-C₆-haloalkylsulfanyl, NR^{I4a}R^{I4b}, C₆-C₁₄-aryl or hetaryl having 4 to 13 carbon atoms, wherein hetaryl has 1, 2 or 3 identical or different heteroatoms or heteroatom-containing groups as ring members, selected from N, NR^{I7}, O, S, SO and SO₂, wherein aryl and hetaryl are unsubstituted or substituted by 1, 2, 3, 4 or 5 identical or different radicals R^{I8};
   - R^{I3}: represents hydrogen, CN, nitro, halogen, C₁-C₆-alkyl, C₁-C₆-haloalkyl, C₁-C₆-alkoxy, C₁-C₆-haloalkoxy, C₁-C₆-alkylsulfanyl, C₁-C₆-haloalkylsulfanyl, NR^{I4a}R^{I4b}, C₆-C₁₄-aryl or hetaryl having 4 to 13 carbon atoms, wherein hetaryl has 1, 2 or 3 identical or different heteroatoms or heteroatom-containing groups as ring members, selected from N, NR^{I7}, O, S, SO and SO₂, wherein aryl and hetaryl are unsubstituted or substituted by 1, 2, 3, 4 or 5 identical or different radicals R^{I5};
   - R^{I4a}R^{I4b}: independently from each other represent hydrogen, C₁-C₆-alkyl or C₆-C₁₄-aryl, wherein aryl is unsubstituted or substituted by 1, 2, 3, 4 or 5 identical or different radicals R^{I5};
   - R^{I5}: represents CN, halogen, C₁-C₄-alkyl or C₁-C₄-haloalkyl;
   - R^{I6}: represents hydrogen, C₁-C₆-alkyl, C₁-C₆-haloalkyl, C₆-C₁₄-aryl or hetaryl having 4 to 13 carbon atoms, wherein hetaryl has 1, 2 or 3 identical or different heteroatoms or heteroatom-containing groups as ring members, selected from N, NR^{I7}, O, S, SO and SO₂, wherein aryl and hetaryl are unsubstituted or substituted by 1, 2, 3, 4 or 5 identical or different radicals R^{I5};
   - R^{I7}: represents hydrogen, C₁-C₆-alkyl, C₁-C₆-haloalkyl or C₆-C₁₄-aryl, wherein aryl is unsubstituted or substituted by 1, 2, 3, 4 or 5 identical or different radicals R^{I5};
   - R^{I8}: represents CN, halogen, C₁-C₄-alkyl, C₁-C₄-haloalkyl or C₆-C₁₄-aryl, which is unsubstituted or substituted by 1, 2 or 3 identical or different radicals selected from C₁-C₄-alkyl and C₁-C₄-haloalkyl.

Preferred are OLEDs comprising compounds of general formula (I) wherein L_{IA}, L_{IB}, L_{IC}, and L_{ID} have the same meaning.

In a preferred embodiment, the organic light-emitting diode comprises a deep-LUMO p-dopant according to formula (I) or formula (I.a) and a ligand according to formula (I.b) with the following parameters: for R^{I1}, R^{I2}, R^{I3} that are present, the corresponding σ^{x} is >0.05, with being the Hammett constant of R^{x}; whereby, with σ^{total}>0.5, with σ^{total}= σ¹+ σ²+σ³ and σ^{x} being the Hammett constant of R^{Ix} (if present).

Preferably, each ligand comprises electron withdrawing groups showing a Hamett's substituent constant, wherein the sum of the **Hamett's substituent constants** of all electron withdrawing groups of one ligand is larger than 0.05, more preferably larger than 0,3, even more preferably larger than 0,5.

### Cerium-Compounds of formula (II)

In one embodiment, the deep LUMO p-dopant is a compound of the general formula (II)

[Ce⁴⁺]₂[(L_{II})ₙ]⁸⁻ (II),

wherein n is an integer from 1 to 8,
wherein L_{II} is independently of each other a ligand with at least five carbon atoms.

In one embodiment, the deep LUMO **p-dopant** is a compound of the general formula (II)

**[Ce⁴⁺]₂[(L_{II})ₙ]⁸⁻** **(II),**

wherein n is 4,
wherein L_{II} is independently of each other a ligand with at least five carbon atoms.

Preferred are OLEDs comprising compounds of general formula (II) wherein L_{II} have the same meaning.

Preferably, n is 4 and L_{II} is a bis-bidentate ligand, comprising at least one compound of the formula (Il.a):

[Ce⁴⁺]₂L_{IIA}²⁻L_{IIB}²⁻L_{IIC}²⁻L_{IID}²⁻ (II.a)

wherein L_{IIA;} L_{IIB;} L_{IIC;} and L_{IID} have the same or different meanings,
wherein
L_{IIA;} L_{IIB;} L_{IIC;} and L_{IID} are each a bis-bidentate ligand independently selected from formula (Il.b) 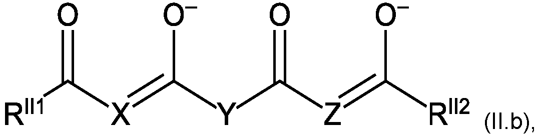 wherein
   **X** is selected from C-H, C-CF₃ and C-R^{II3};
   **Z** is selected from C-H, C-CF₃ and C-R^{II4};
   **R^{II1}, R^{II2}, R^{II3} and R^{II4}** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl or C₁-C₆-haloalkyl,
      wherein aryl and heteroaryl are unsubstituted or substituted by 1, 2, 3, 4 or 5 identical or different radicals R^{II5};
   wherein R^{II5} is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl; wherein
   Y is selected from C₆-C₁₄-arylene, 4- to 14-membered heteroarylene having 1, 2 or 3 identical or different heteroatoms or heteroatom-containing groups as ring members, selected from N, O, and S, C₁-C₁₀-alkylene, C₃-C₆-cycloalkylene, C₃-C₆-cycloalkenylene, C₁-C₁₀-haloalkylene, C₁-C₁₀-haloalkylarylene,;
      wherein arylene and heteroarylene are unsubstituted or substituted by 1, 2, 3, 4 or 5 identical or different radicals R^{II5};
      wherein R^{II5} is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl
      wherein **R^{II6}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
      wherein **R^{II7}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
      wherein **R^{II8}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkylene;
      wherein **R^{II9}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
      wherein **R^{II10}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.

Preferably, n is 4 and L_{II} is a bis-bidentate ligand, comprising at least one compound of the formula (II.a):

[Ce⁴⁺]₂L_{IIA}²⁻L_{IIB}²⁻L_{IIC}²⁻L_{IID}²⁻ (II.a)

wherein L_{IIA;} L_{IIB;} L_{IIC;} and L_{IID} have the same or different meanings,
wherein
L_{IIA;} L_{IIB;} L_{IIC;} and L_{IID} are each a bis-bidentate ligand independently selected from formula (Il.b) 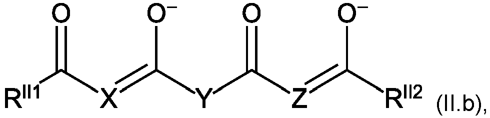 wherein
   **X** is selected from C-H, C-CF₃ and C-R^{II3};
   **Z** is selected from C-H, C-CF₃ and C-R^{II4};
   **R^{II1}, R^{II2}, R^{II3} and R^{II4}** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl or C₁-C₆-haloalkyl,
      wherein aryl and heteroaryl are unsubstituted or substituted by 1, 2, 3, 4 or 5 identical or different radicals R^{II5};
   wherein R^{II5} is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl; wherein
   Y is selected from C₆-C₁₄-arylene, 4- to 14-membered heteroarylene having 1, 2 or 3 identical or different heteroatoms or heteroatom-containing groups as ring members, selected from N, O, S, SO and SO₂, C₁-C₁₀-alkylene, C₃-C₆-cycloalkylene, C₃-C₆-cycloalkenylene, C₁-C₁₀-haloalkylene, C₁-C₁₀-haloalkylarylene, S, S-O, O, P-**R^{II6}**, P-O-R^{II7}, Si-(R^{II8})₂, B-R^{II9} and N-R^{II10};
      wherein arylene and heteroarylene are unsubstituted or substituted by 1, 2, 3, 4 or 5 identical or different radicals R^{II5};
      wherein R^{II5} is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl
      wherein **R^{II6}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
      wherein **R^{II7}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
      wherein **R^{II8}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkylene;
      wherein **R^{II9}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
      wherein **R^{II10}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.

Preferred are OLEDs comprising compounds of general formula (II) wherein L_{IIA}, L_{IIB}, L_{IIC}, and L_{IID} have the same meaning.

In one embodiment of an organic light-emitting diode, the deep LUMO p-dopant is a compound of the general formula (I)

[Ce⁴⁺][(L_{I})₄]⁴⁻ (I),

wherein L_{I} is independently of each other a ligand with at least five carbon atoms or the deep LUMO p-dopant is a compound of the general formula (II)

**[Ce⁴⁺]₂[(L_{II})ₙ]⁸⁻** **(II),**

wherein n is an integer from 1 to 8,
wherein L_{II} is independently of each other a ligand with at least five carbon atoms.

In one embodiment of an organic light-emitting diode, the deep LUMO p-dopant is a compound of the general formula (I)

[Ce⁴⁺][(L_{I})₄]⁴⁻ (I),

wherein L_{I} is a ligand with at least five carbon atoms, wherein all ligands have the same meaning and wherein each ligand comprises electron withdrawing groups showing a Hamett's substituent constant, wherein the sum of the Hamett's substituent constants of all electron withdrawing groups of one ligand is larger than 0.05, more preferably larger than 0,3, even more preferably larger than 0,5, or
the deep LUMO p-dopant is a compound of the general formula (II)

   **[Ce⁴⁺]₂[(L_{II})ₙ]⁸⁻** **(II),**

   wherein n is an integer from 1 to 8,
   wherein L_{II} is independently of each other a ligand with at least five carbon atoms.

Advantageously, such an OLED comprises strong deep-LUMO p-dopants leading to improved properties and accordingly, a high power efficiency.

### OLED structure

Preferred are organic light-emitting diodes comprising:
- an anode layer, a cathode layer, and several organic layers arranged between the anode layer and the cathode layer, including at least a blue phosphorescent emissive layer and at least one deep-HOMO p-doped semiconductor layer,
- Wherein the blue phosphorescent emissive layer comprises at least one blue phosphorescent emitter material and an emitter host material,
- wherein the deep HOMO p-doped semiconductor layer is preferably arranged between the anode layer and the blue phosphorescent emissive layer,

wherein the deep HOMO p-doped semiconductor layer comprises a deep-HOMO hole transport material and a deep-LUMO p-dopant,
wherein the HOMO of the deep-HOMO hole transport material is in the range between - 5.0 eV and -6.0 eV when determined by DFT calculations, preferably at least as deep as BPAPF if measured with the same method or wherein the HOMO of the deep-HOMO hole transport material is preferably in the range between -5.05 eV and -6.0 eV when determined by DFT calculations, and
wherein the deep-LUMO p-dopant is an organometallic complex comprising Ce(IV) and wherein the LUMO of the deep LUMO p-dopant is in the range between -4.9 eV and -5.8 eV, when determined by DFT calculations.

Preferably, the LUMO of the deep LUMO p-dopant is in the range between -5.0 eV and - 5.6 eV when determined by DFT calculations, more preferably the LUMO of the deep LUMO p-dopant is at least as deep as the LUMO of Tetrakis[1-[3,5-bis(trifluoromethyl)phenyl]-4,4,4-trifluoro-1,3-butanedionato-κO1,κO3]cerium if measured with the same method.

One embodiment is an organic light-emitting diode, wherein the deep-HOMO p-doped semiconductor layer comprises a deep-HOMO hole transport material and a deep-LUMO p-dopant, in particular a compound of general formula (I) or a compound of general formula (II), and wherein the HOMO of the deep-HOMO hole transport material is preferably at least as deep as BPAPF if measured with the same method or wherein the HOMO of the deep-HOMO hole transport material is preferably in the range between - 5.05 eV and -6.0 eV when determined by DFT calculations.

Preferred is an organic light-emitting diode, wherein the deep-HOMO p-doped semiconductor layer comprises a deep-HOMO hole transport material and a deep-LUMO p-dopant, in particular a compound of general formula (I) or a compound of general formula (II), and the blue phosphorescent emissive layer comprises at least one deep-HOMO emitter host material, wherein the HOMO level of the deep-HOMO emitter host material (EML-host) of the blue phosphorescent emissive layer and the HOMO level of the deep-HOMO hole transport material (HTM1) fulfill the following equation: $- 1.0 eV < HOMO \left(EML-host\right) - HOMO \left(HTM1\right) < 0.0 eV ,$ when determined by DFT calculations.

Even more preferably the following equation is fulfilled: -0.8 eV < HOMO (EML-host) - HOMO (HTM) < -0.25 eV.

The use of deep-HOMO hole transport materials in p-doped semiconductor layers, such as hole injection layers or hole transport layers, allows advantageously for the application of emitter host materials with even deeper HOMO levels leading to a better confinement of excitons and an improvement of the efficiency of the blue emission.

Preferred is an organic light-emitting diode, wherein at least one of the organic layers is an undoped hole-transport material layer which is positioned between the deep-HOMO p-doped semiconductor layer and the blue phosphorescent emissive layer, and wherein the HOMO levels of the undoped hole-transport material layer (HTM2), the HOMO of the deep-HOMO hole transport material (HTM1), and the HOMO of the emitter host material (EML-host) of the blue phosphorescent emissive layer fulfill the following equation: $HOMO \left(HTM1\right) \geq HOMO \left(HTM2\right) \geq HOMO \left(EML-host\right) .$

Here, the undoped hole transport layer is arranged preferably adjacent to the deep HOMO p-doped semiconductor layer. The undoped hole transport layer is essentially free from any dopant molecules but may comprise traces of the p-dopant due to interdiffusion from adjacent layers. The deep-HOMO p-doped semiconductor layer comprises at least one deep-LUMO p-dopant according to the invention, in particular a compound of general formula (I) or a compound of general formula (II).

Preferred is an organic light-emitting diode, wherein one of the organic layers which are arranged between the anode layer and the cathode layer is an **undoped hole transport material layer** which is positioned between the deep HOMO p-doped semiconductor layer and the blue phosphorescent emissive layer, wherein the undoped hole transport layer is arranged adjacent to the deep HOMO p-type semiconductor layer and adjacent to the blue phosphorescent emissive layer. Accordingly, there is no additional layer between the deep HOMO p-type semiconductor layer and the undoped hole transport layer as well as there is no additional layer between the undoped hole transport material layer and the blue phosphorescent emissive layer.

In another embodiment, the organic light-emitting diode comprises a second undoped hole-transport material layer, which is arranged between the first undoped hole transport material layer and the blue phosphorescent emissive layer.

In one embodiment, the organic light-emitting diode is a multi-stack OLED comprising at least one blue phosphorescent emissive layer, e.g. a tandem device comprising a blue phosphorescent emissive layer and a second emissive layer. In one embodiment, the organic light-emitting diode is a triplet or a quadruple device comprising an additional third emissive layer or a third and a fourth emissive layer, respectively. The second, third, and/or fourth emissive layers may be blue phosphorescent emissive layers. They may also be emissive layers comprising different emitter materials, such as green, red, or yellow phosphorescent emitter materials, or blue fluorescent emitter materials. The different emissive layers can be arranged in different orders.

In the context of the invention, the general term "multi-stack device" or "multi-stack organic light-emitting diode" means an organic light-emitting diode comprising two or more vertically stacked units each one comprising at least one emissive layer and wherein, the two or more units are connected by charge generation layers.

In a preferred embodiment, the light-emitting diode is a multi-stack organic light-emitting diode, which comprises several units each comprising one emissive layer. For such a multi-stack organic light-emitting diode, it is preferred that the deep-HOMO p-type semiconductor layer and the blue phosphorescent emissive layer are part of the same OLED unit. Accordingly, there is no additional emissive layer comprising another emitter material positioned between the deep-HOMO p-type semiconductor layer and the blue phosphorescent emissive layer.

In the context of the present specification, the term "charge generation layer" is related to a p-type semiconductor layer that is positioned in vicinity of an n-type semiconductor layer between two emissive layers and is built to enable the generation of charge carriers in such a way that both emissive layers can be driven. The p-type and the n-type semiconductor layers of the charge generation layer may be directly adjacent to each other or separated by an interlayer.

In one embodiment, the deep-HOMO p-doped semiconductor layer, which comprises the deep-HOMO hole transport material and the deep-LUMO p-dopant, is a p-type charge generation layer positioned between two emissive layers, wherein at least one of the emissive layers is the blue phosphorescent emissive layer and the blue phosphorescent emissive layer is closer to the p-type charge generation layer than to the n-type charge-generation layer. In a preferred embodiment, there is an interlayer positioned between the p-type and n-type charge-generation layer. The interlayer may consist of an organic material, a metal, a metal complex, or a metal oxide and preferably has a thickness of less than 10 nm. The interlayer may consist of several sublayers.

Preferred is an organic light-emitting diode comprising at least two units each comprising at least one blue phosphorescent emissive layer, wherein the organic light-emitting diode can be called multi-stack organic light-emitting diode. Thereby, the organic light-emitting diode comprises an anode layer, a cathode layer, and several organic layers arranged between the anode layer and the cathode layer, including at least a first unit comprising a first blue phosphorescent emissive layer and at least a first deep-HOMO p-doped semiconductor layer and a second unit comprising at least a second phosphorescent emissive layer. The first deep HOMO p-doped semiconductor layer comprises a deep-HOMO hole transport material and a deep-LUMO p-dopant. The HOMO of the deep-HOMO hole transport material is in the range between -5.0 eV and -6.0 eV when determined by DFT calculations, and the deep-LUMO p-dopant is an organometallic complex comprising Ce(IV) and wherein the LUMO of the deep LUMO p-dopant is in the range between -4.8 eV and -5.8 eV when determined by DFT calculations.

In addition, the organic light-emitting diode comprises a charge generation layer between the first blue phosphorescent emissive layer and the second blue phosphorescent emissive layer, wherein the charge generation layer comprises a second deep-HOMO p-doped semiconductor layer.

Thereby the first blue phosphorescent emissive layer comprises at least one blue phosphorescent emitter material and an emitter host material and the second blue phosphorescent emissive layer comprises at least one blue phosphorescent emitter material and an emitter host material.

Here, the first deep HOMO p-doped semiconductor layer is arranged between the anode layer and the first blue phosphorescent emissive layer and the first deep HOMO p-doped semiconductor layer comprises a first deep-HOMO hole transport material and a first deep-LUMO p-dopant and the second deep HOMO p-doped semiconductor layer comprises a second deep-HOMO hole transport material and a second deep-LUMO p-dopant. The HOMO of the first deep-HOMO hole transport material is in the range between -5.0 eV and -6.0 eV when determined by DFT calculations, and the first deep-LUMO p-dopant is an organometallic complex comprising Ce(IV), wherein the LUMO of the deep LUMO p-dopant is in the range between -4.8 eV and -5.8 eV when determined by DFT calculations.

The HOMO of the second deep-HOMO hole transport material is in the range between - 5.0 eV and -6.0 eV when determined by DFT calculations, and the second deep-LUMO p-dopant is an organometallic complex comprising Ce(IV), wherein the LUMO of the second deep LUMO p-dopant is in the range between -4.8 eV and -5.8 eV when determined by DFT calculations.

The first deep-LUMO p-dopant and the second deep-LUMO p-dopant can be the same or they can be different compounds. The first deep-HOMO hole transport material and the second deep-HOMO hole transport material can be the same material or different materials.

A deep-HOMO p-doped semiconductor layer is optionally a hole injection layer. A **hole injection layer** is generally a layer that facilitates hole injection from the anode into the semiconductor matrix material. The hole injection layer can be placed directly adjacent to the anode. The anode may or may not be composed of several sublayers.

In certain embodiments, the p-doped semiconductor layer has a thickness which is smaller than or equal to 200 nm, preferably smaller than or equal to 100 nm.

Preferably, the p-doped semiconductor layer has a thickness in a range from 2 to 100 nm, more preferably, between 5 nm and 15 nm.

In a preferred embodiment of the organic light-emitting diode, the deep HOMO p-doped semiconductor layer is positioned adjacent to the anode.

The deep HOMO p-doped semiconductor layer may consist of at least **a first sublayer and a second sublayer,** wherein the first sublayer is arranged next to the anode and comprises a deep-LUMO p-dopant or the first sublayer which is positioned adjacent to the anode consists of the deep-LUMO p-dopant, and wherein the deep-LUMO p-dopant is an organometallic complex comprising Ce(IV), preferably a compound according to general formula (I) or a compound of general formula (II). In addition, the second sublayer of the deep-HOMO p-doped semiconductor layer comprises a deep-HOMO hole transport material or consists of a deep-HOMO hole transport material. The second sublayer is preferably positioned adjacent to the first sublayer. The deep HOMO p-doped semiconductor layer may even comprise additional sublayers, for example blocking layers.

In one embodiment, the deep-HOMO hole transport material and the deep-LUMO p-dopant are arranged in a **mixed layer,** for example the deep-LUMO p-dopant is doped into the deep-HOMO hole transport material.

In one embodiment, the **conductivity** of the deep HOMO p-doped semiconductor layer is in the range of 1E-6 to 1E-3 S/cm, preferably between 3E-6 to 1E-4 S/cm, wherein the conductivity is measured in a lateral configuration by a transmission line method at room temperature.

The organic light-emitting diode may also comprise other layers. For example, one or more each of hole blocking layers, electron transport layers, electron injection layers, electron blocking layers, exciton blocking layers, charge conversion contacts and/or charge generation layers, both also referred to as pn-junctions. Not each of these layers must necessarily be present. Preferably, the organic light-emitting diode, also comprises a substrate such as a metal, glass, or plastic substrate.

In one embodiment, the organic light-emitting diode may comprise a deep HOMO p-doped semiconductor layer comprising a deep-LUMO p-dopant, in particular a compound of general formula (I) or a compound of general formula (II), and the organic light-emitting diode may also comprise a **second p-dopant** which differs from the deep-LUMO p-dopant, in particular a p-dopant such as the class of 3-radialenes, preferably α,α',α"-1,2,3-Cyclopropanetriylidenetris[4-cyano-2,3,5,6-tetrafluorobenzeneacetonitrile], from the class of dicyanochinodimethane-derivatives, preferably 2,3,5,6-Tetrafluor-7,7,8,8-tetracyanochindimethan, 2,2'-(1,3,4,5,7,8-Hexafluoro-2,6-naphthalenediylidene)bis[propanedinitrile], 2,2'-[4,8-Bis[2,4-bis(trifluoromethyl)phenyl]benzo[1,2-d:4,5-d']bisoxazole-2,6-diylidene]bis[propanedinitrile], from the class of metal complexes, in particular cerium(IV) diketonates and derivatives or from the class of benzobisoxazole and derivatives such as 2,2'-[4,8-Bis[2,4-bis(trifluoromethyl)phenyl]benzo[1,2-d:4,5-d']bisoxazole-2,6-diylidene]bis[propanedinitrile]. The second p-dopant may be present in the same or a different layer or sub-layer than the deep-LUMO p-dopant.

Accordingly, the organic light-emitting diode may comprise the deep HOMO p-doped semiconductor layer comprising a deep-LUMO p-dopant and it may also comprise a second p-type semiconductor layer, e.g. a charge generation layer or a hole injection layer, comprising a p-dopant such as mentioned above.

In a preferred embodiment, the organic light-emitting diode is a multi-stack organic light-emitting diode comprising at least two units, wherein the first unit comprises at least one first emissive layer comprising a blue phosphorescent emitter material and at least one deep-HOMO p-doped semiconductor layer and the second unit comprises a second emissive layer without a blue phosphorescent emitter material. The second unit may comprise different emitter materials, such as blue fluorescent emitters or phosphorescent emitters of other colors. The first unit is closer to the anode than the second unit. Here, the deep-HOMO p-doped semiconductor layer is arranged between the anode layer and the blue phosphorescent emissive layer and the deep HOMO p-doped semiconductor layer comprises a deep-HOMO hole transport material and a deep-LUMO p-dopant. The HOMO of the deep-HOMO hole transport material is in the range between -5.0 eV and - 6.0 eV when determined by DFT calculations, and the deep-LUMO p-dopant is an organometallic complex comprising Ce(IV) and wherein the LUMO of the deep LUMO p-dopant is in the range between -4.8 eV and -5.8 eV when determined by DFT calculations. Here, the p-type charge generation layer positioned between the first and the second emissive layer may be free of an organometallic complex comprising Ce(IV) according to the invention. The p-type charge generation layer may comprise a second p-dopant which differs from the deep-LUMO p-dopant, in particular a p-dopant such as the class of 3-radialenes, preferably α,α',α"-1,2,3-Cyclopropanetriylidenetris[4-cyano-2,3,5,6-tetrafluorobenzeneacetonitrile], from the class of dicyanochinodimethane-derivatives, preferably 2,3,5,6-Tetrafluor-7,7,8,8-tetracyanochindimethan, 2,2'-(1,3,4,5,7,8-Hexafluoro-2,6-naphthalenediylidene)bis[propanedinitrile], 2,2'-[4,8-Bis[2,4-bis(trifluoromethyl)phenyl]benzo[1,2-d:4,5-d']bisoxazole-2,6-diylidene]bis[propanedinitrile], from the class of metal complexes, in particular cerium(IV) diketonates and derivatives or from the class of benzobisoxazole and derivatives such as 2,2'-[4,8-Bis[2,4-bis(trifluoromethyl)phenyl]benzo[1,2-d:4,5-d']bisoxazole-2,6-diylidene]bis[propanedinitrile].

### Semiconductor matrix materials as deep-HOMO hole transport materials

Preferred is an organic light-emitting diode, wherein the deep HOMO p-doped semiconductor layer comprises a deep-HOMO hole transport material, i.e. a semiconductor matrix material and a deep-LUMO p-dopant.

The deep-LUMO p-dopant according to the invention, the charge transfer complexes thereof, and the reduction products thereof are used as dopants in the deep-HOMO hole transport material. The deep HOMO p-doped semiconductor material is preferably an electron donor, which is preferably a triaryl amine based compound, comprising at least one or more nitrogen atoms exhaustively substituted by aromatic moieties.

Possible electron donors are diaminoterphenyls, diaminotrimethylphenylindanes, and Di-, tri- and tetraphenylindane amine derivatives.

Suitable diaminoterphenyls are described in DE 102012007795.

Diaminotrimethylphenylindanes are described in WO 2018/206769.

Di-, tri- and tetraphenylindane amine derivatives are described in WO2020094847.

The deep-HOMO hole transport material can be selected from triarylamines. Especially, the deep-HOMO hole transport material can be selected from hole transport materials that are typically used in electron blocker layers and/or used as emitter host materials.

Especially the deep-HOMO hole transport materials can be selected from 9,9-bis[4-(N,N-bis-biphenyl-4-yl-amino)phenyl]-9H-fluorene, N,N'-((9H-fluorene-9,9-diyl)bis(4,1-phenylene))bis(N-([1,1'-biphenyl]-4-yl)-[1,1'-biphenyl]-4-amine) (BPAPF), tri(terphenyl-4-yl)amine, 9-(4-(6-(9H-carbazol-9-yl)-1,3,3-trimethyl-2,3-dihydro-1H-inden-1-yl)phenyl)-9H-carbazole, N,N-di([1,1'-biphenyl]-4-yl)-4'-(6-(4-(di([1,1'-biphenyl]-4-yl)amino)phenyl)-1,3,3-trimethyl-2,3-dihydro-1H-indene-1-yl)-[1,1'-biphenyl]-4-amine, N,N-Di([1,1'-biphenyl]-4-yl)-4'-(9H-carbazol-9-yl)-[1,1'-biphenyl]-4-amine, 4,4',4"-Tris(carbazol-9-yl)-triphenylamine, N,N-Bis(4-(dibenzo[b,d]furan-4-yl)phenyl)-[1,1':4',1"-terphenyl]-4-amine, N,N-Di([1,1'-biphenyl]-4-yl)-4'-(9H-carbazol-9-yl)-[1,1'-biphenyl]-4-amine and mixtures thereof.

The deep-HOMO hole transport materials can also be selected from non-triarylamine compounds, in particular from materials used as emitter host materials with hole-transporting properties, for example, 1,3-Bis(N-carbazolyl)benzene (mCP), 3,3'-Di(9H-carbazol-9-yl)-1,1'-biphenyl (mCBP), 2,2'-di(9H-carbazol-9-yl)-1,1'-biphenyl (oCBP), 9-(3-(triphenylsilyl)phenyl)-9H-3,9'-bicarbazole (SiCzCz), 9,9'-Bis([1,1'-biphenyl]-4-yl)-3,3'-bi-9H-carbazole.

In particular, such dopable deep-HOMO hole transport material, in particular hole transport materials, can be arylated benzidines, e.g., N,N'-perarylated benzidines or other diamines such as of the type TPD (in which one, several or all of the aryl groups can have aromatic heteroatoms), suitable arylated starburst compounds such as N,N',N"-perarylated starburst compounds such as the compound TDATA (in which one, several or all of the aryl groups can have aromatic heteroatoms). The aryl groups can comprise carbazole, phenyl, naphthyl, pyridine, quinoline, isoquinoline, peridazine, pyrimidine, pyrazine, pyrazole, imidazole, oxazole, furan, pyrrole, indole or the like, especially for each of the above-cited compounds. The phenyl groups of the particular compounds can be partially or completely replaced by thiophene groups.

It is understood that even other suitable deep-HOMO hole transport materials, in particular hole-conducting materials can be used that have semi-conductive properties.

### Doping

In particular, the doping can be carried out such that the molar ratio of matrix molecules to the compound of the general formula (I), is in the range from 10000 : 1 to 1 : 1, preferably from 100 : 1 to 2 : 1, particularly preferably from 100 : 2 to 5 : 1.

Preferably, the compounds according to the invention are characterized by a preferential doping efficiency.

Advantageously, the deep-LUMO p-dopants lead to a conductivity of the deep HOMO p-doped semiconductor layer in the range of 1E-6 to 1E-3 S/cm, preferably between 3E-6 to 1E-4 S/cm. Thus, the driving voltage, which can also be called operating voltage, of the OLED is advantageously low.

### Preparation of the deep-HOMO p-doped semiconductor layer

A further object of the invention relates to the doping of the respective deep-HOMO hole transport material (hereinafter also referred to as hole transport material (HTM) which can also be referred to as hole conductor matrix) with the deep-LUMO p-dopants according to the invention and used in accordance with the invention may be carried out by one or a combination of two or more than two of the following processes:
(a) Simultaneous evaporation of the deep-HOMO hole transport material and the deep-LUMO p-dopant, preferably in vacuum, preferably with one source for the deep-HOMO hole transport material and one for at least one deep-LUMO p-dopant.
(b) Evaporation of a pre-mixed material containing the deep-HOMO hole transport material and at least one deep-LUMO p-dopant from one single source.
(c) Sequential deposition of the deep-HOMO hole transport material and at least one deep-LUMO p-dopant. This process step is followed by diffusion of the dopant, i.e. the deep-LUMO p-dopant diffuses into the deep-HOMO hole transport material upon thermal treatment. The deep-LUMO p-dopant might be deposited before or after the deep-HOMO hole transport material.
(d) Doping of a layer of a deep-HOMO hole transport material by a solution of at least one deep-LUMO p-dopant followed by evaporation of the solvent by thermal treatment.
(e) Surface doping of a layer of a deep-HOMO hole transport material by a layer of at least one deep-LUMO p-dopant applied to one or both surfaces of the HT layer (hole transport layer), i.e. a layer comprising a deep-HOMO hole transport material.
(f) Preparing a solution of a deep-HOMO hole transport material and at least one deep-LUMO p-dopant and forming a film from the solution, e.g., by coating, casting, printing, or other film-forming techniques known to one skilled in the art.

The invention will be illustrated further with reference to the examples that follow, without restricting the scope to the specific embodiments described. The invention includes all combinations of described and especially of preferred features that do not exclude each other.

### Abbreviation:

- HOMO: Highest occupied molecular orbital
- LUMO: Lowest unoccupied molecular orbital
- HAT-CN: 1,4,5,8,9,11-Hexaazatriphenylenehexacarbonitrile
- BPAPF: N,N'-((9H-fluorene-9,9-diyl)bis(4,1-phenylene))bis(N-([1,1'-biphenyl]-4-yl)-[1, 1'-biphenyl]-4-amine
- BCFN: N-([1,1'-biphenyl]-4-yl)-9,9-dimethyl-N-(4-(9-phenyl-9H-carbazol-3-yl)phenyl)-9H-fluoren-2-amine
- TCTA: 4,4',"-Tris(carbazol-9-yl)triphenylamine
- mCP: 1,3-Bis(N-carbazolyl)benzene
- B3PyMPM: 4,6-Bis(3,5-di(pyridin-3-yl)phenyl)-2-methylpyrimidine
- Al: Aluminium
- BPhen: 4,7-Diphenyl-1,10-phenanthrolin
- Cs: Caesium
- acac: acetylacetone
- ITO: Indium Tin Oxide
- HIL: Hole injection layer
- HTL: Hole transport layer
- EQE: External Quantum Efficiency
- PE: Power Efficiency
- n.d.: not defines/measured

The invention will be illustrated further with reference to the examples and the specific embodiments that follow, without restricting the scope to the specific embodiments or examples described. The invention includes all combinations of the described embodiments or examples and especially of preferred features that do not exclude each other.

### Description of the Drawings

The electronic components described, along with the claimed components and those intended for use in the invention as detailed in the described embodiments, are not constrained by any specific exceptions regarding size, shape, material selection, or technical concept. Therefore, the standard selection criteria known in the relevant field can be applied without any restrictions. Further specifics, features, and benefits of the object can be found in the dependent claims and the subsequent description of the corresponding figures, which illustrate optional embodiments of the invention in an exemplary manner. However, it should be noted that any given embodiment does not necessarily cover the entire scope of the invention, and thus the claims and this description should be referred to for interpreting the scope. It is important to understand that both the preceding general description and the following detailed description are intended solely as illustrative and explanatory, providing additional insight into the present invention as claimed.

### Figures 1 to 4

- FIG. 1: is a schematic sectional view of an OLED comprising a blue emissive layer and a deep-HOMO hole transport layer according to an exemplary embodiment of the present invention.
- FIG. 2: is a schematic sectional view of an OLED according to an exemplary embodiment of the present invention.
- Fig. 3: is a schematic sectional view of a tandem OLED comprising two units according to an exemplary embodiment of the present invention.
- Fig. 4: is a schematic sectional view of a tandem OLED comprising two units according to an exemplary embodiment of the present invention.

The following figures are described in more detail using examples. It should be noted that the present disclosure is not limited to these exemplary embodiments. In this context, when a first element is said to be formed or placed "on" or "onto" a second element, it may be positioned directly on the second element or with one or more intervening elements in between. Conversely, when a first element is described as being formed or placed "directly on" or "directly onto" or "directly adjacent" or "adjacent" a second element, it means there are no intervening elements in between the first element and the second element.

The same reference sign belongs to the same component in every figure.

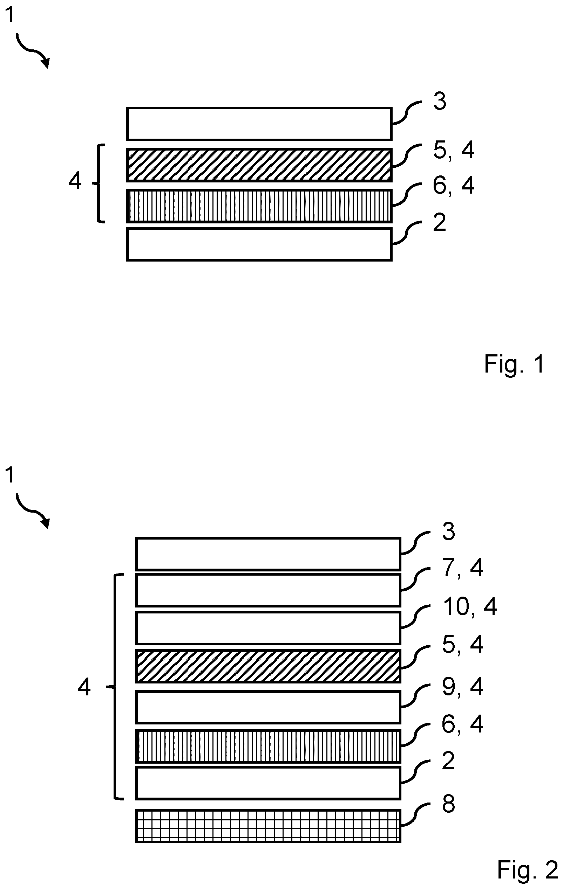

An organic light-emitting diode (OLED) 1 is shown in **Fig. 1** in a schematic sectional view. The OLED 1 comprises an anode layer 2, a cathode layer 3 and several organic layers 4 which are arranged between the anode layer 2 and the cathode layer 3. One of the organic layers 4 is a blue phosphorescent emissive layer 5, which comprises a phosphorescent emitter material and an emitter host material, and one layer is a deep-HOMO p-doped semiconductor layer 6 comprising a deep-HOMO hole transport material and a deep-LUMO p-dopant.

The HOMO of the deep-HOMO hole transport material is in the range between -5.0 eV and -6.0 eV when determined by DFT calculations, and the deep-LUMO p-dopant is an organometallic complex comprising Ce(IV) and wherein the LUMO of the deep LUMO p-dopant is in the range between -4.8 eV and -5.8 eV when determined by DFT calculations.

**Fig. 2** shows a schematic sectional view of an OLED, which comprises an anode layer 2, a cathode layer 3 and several organic layers 4 which are arranged between the anode layer 2 and the cathode layer 3. One of the organic layers 4 is a blue phosphorescent emissive layer 5, which comprises a phosphorescent emitter material and an emitter host material, and one of the layers is a deep-HOMO p-doped semiconductor layer 6 comprising a deep-HOMO hole transport materials and a deep-LUMO p-dopant. The HOMO of the deep-HOMO hole transport material is in the range between -5.0 eV and - 6.0 eV when determined by DFT calculations, and the deep-LUMO p-dopant is an organometallic complex comprising Ce(IV) and wherein the LUMO of the deep LUMO p-dopant is in the range between -4.8 eV and -5.8 eV when determined by DFT calculations.

In addition, there might be an electron injection layer 7 and a substrate 8. The OLED further comprises a hole transport layer 9 which is arranged between the emissive layer 5 and the deep-HOMO p-doped semiconductor layer 6. The hole transport layer 9 can be an intrinsic layer. Furthermore, there is an electron transport layer 10, which is arranged between the emissive layer 5 and the electron injection layer 7.

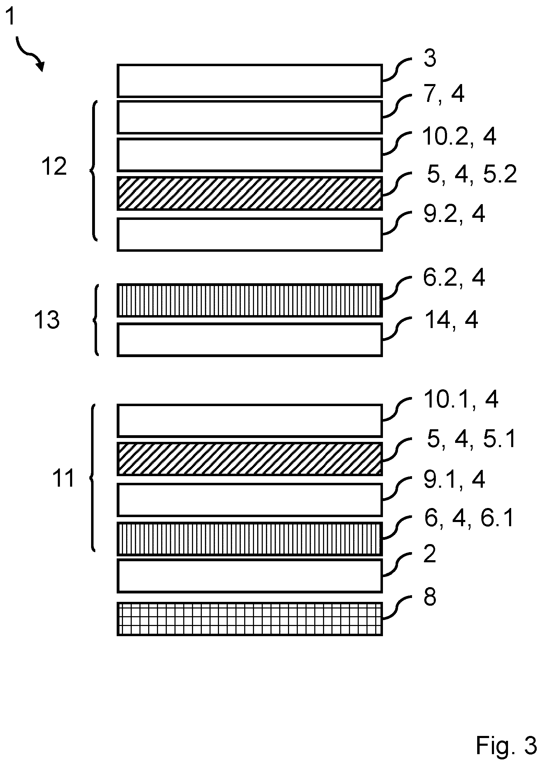

**Fig. 3** shows an exemplary embodiment of an OLED 1 which comprises an anode layer 2, a cathode layer 3 and several organic layers 4 which are arranged between the anode layer 2 and the cathode layer 3. This OLED 1 is a multi-stack light-emitting diode 1. It comprises at least two units each comprising several organic layers 4, wherein each unit comprises at least one blue phosphorescent emissive layer 5. The organic light-emitting diode 1 comprises an anode layer 2, a cathode layer 3, and several organic layers 4 arranged between the anode layer 2 and the cathode layer 3. The OLED 1 comprises at least a first unit 11 comprising a first blue phosphorescent emissive layer 5.1 and at least a first deep-HOMO p-doped semiconductor layer 6.1. The first deep HOMO p-doped semiconductor layer 6.1 comprises a deep-HOMO hole transport material and a deep-LUMO p-dopant. The HOMO of the deep-HOMO hole transport material is in the range between -5.0 eV and -6.0 eV when determined by DFT calculations, and the deep-LUMO p-dopant is an organometallic complex comprising Ce(IV) and wherein the LUMO of the deep LUMO p-dopant is in the range between -4.8 eV and -5.8 eV when determined by DFT calculations.

The OLED 1 further comprises a second unit 12 comprising at least a second phosphorescent emissive layer 5.2. In addition, the organic light-emitting diode comprises a charge generation layer 13 between the first blue phosphorescent emissive layer 5.1 and the second blue phosphorescent emissive layer 5.2, wherein the charge generation layer 13 comprises a second deep-HOMO p-doped semiconductor layer 6.2 which is a p-type charge generation layer. The second deep HOMO p-doped semiconductor layer 6.2 comprises a deep-HOMO hole transport material and a deep-LUMO p-dopant. The HOMO of the deep-HOMO hole transport material is in the range between -5.0 eV and - 6.0 eV when determined by DFT calculations, and the deep-LUMO p-dopant is an organometallic complex comprising Ce(IV) and wherein the LUMO of the deep LUMO p-dopant is in the range between -4.8 eV and -5.8 eV when determined by DFT calculations.

In an exemplary embodiment, the charge generation layer 13 further comprises an n-type charge generation layer 14.

In addition, there might be further organic layers 4 such as a first hole transport layer 9.1, a second hole transport layer 9.2, a first electron transport layer 10.1, a second electron transport layer 10.2, and an electron injection layer 7.

In addition, there might be a substrate 8. The first hole transport layer 9.1 is arranged between the first blue phosphorescent emissive layer 5.1 and the first deep-HOMO p-doped semiconductor layer 6.1. The second hole transport layer 9.2 is arranged between the second blue phosphorescent emissive layer 5.2 and the second deep-HOMO p-doped semiconductor layer 6.2. The first hole transport layer 9.1 can be an intrinsic layer and the second hole transport layer 9.2 can be an intrinsic layer. The first electron transport layer 10.1 is arranged between the first blue phosphorescent emissive layer 5.1 and the n-type charge generation layer 14. The second electron transport layer 10.2 is arranged between the second blue phosphorescent emissive layer 5.2 and the electron injection layer 7.

The thickness and the material of the corresponding layers of the first unit and the second unit can be identical or different. For example, the material and the thickness of the first hole transport layer 9.1 and of the second hole transport layer 9.2 may be identical or different.

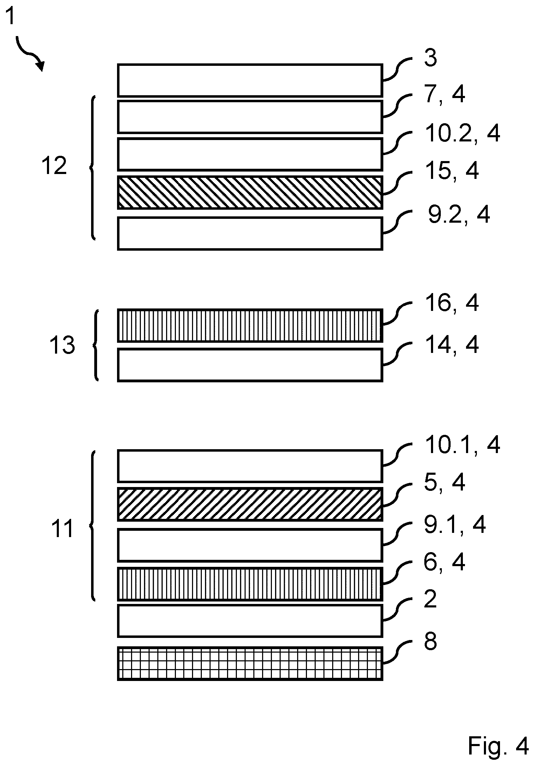

**Fig. 4** shows an OLED 1 in a schematic sectional view, which comprises an anode layer 2, a cathode layer 3 and several organic layers 4 which are arranged between the anode layer 2 and the cathode layer 3. The OLED 1 is a multi-stack OLED 1 which comprises at least two units, wherein each of the units comprises several organic layers 4. In this exemplary embodiment, the first unit 11 comprises at least one first emissive layer, which is a blue phosphorescent emissive layer 5 comprising a blue phosphorescent emitter material. Furthermore, the first unit 11 comprises at least one deep-HOMO p-doped semiconductor layer 6 and the second unit 12 comprises a second emissive layer 15 without a blue phosphorescent emitter material. The second emissive layer 15 of the second unit 12 may comprise one or more different emitter materials, such as blue fluorescent emitter material or a phosphorescent emitter material of another color.

The first unit 11 is closer to the anode layer 2 than the second unit 12. Here, the deep-HOMO p-doped semiconductor layer 6 is arranged between the anode layer 2 and the blue phosphorescent emissive layer 5 and the deep HOMO p-doped semiconductor layer 6 comprises a deep-HOMO hole transport material and a deep-LUMO p-dopant. The HOMO of the deep-HOMO hole transport material is in the range between -5.0 eV and - 6.0 eV when determined by DFT calculations, and the deep-LUMO p-dopant is an organometallic complex comprising Ce(IV) and wherein the LUMO of the deep LUMO p-dopant is in the range between -4.8 eV and -5.8 eV when determined by DFT calculations. There is a charge generation layer 13 between the first unit 11 and the second unit 12. Here, the p-type charge generation layer 16 is positioned between the blue phosphorescent emissive layer 5 and the second emissive layer 15. In an exemplary embodiment, the p-type charge generation layer 16 may be free of an organometallic complex comprising Ce(IV) according to the invention. The p-type charge generation layer 16 may comprise a second p-dopant which differs from the deep-LUMO p-dopant, in particular a p-dopant such as the class of 3-radialenes, preferably α,α',α"-1,2,3-Cyclopropanetriylidenetris[4-cyano-2,3,5,6-tetrafluorobenzeneacetonitrile], from the class of dicyanochinodimethane-derivatives, preferably 2,3,5,6-Tetrafluor-7,7,8,8-tetracyanochindimethan, 2,2'-(1,3,4,5,7,8-Hexafluoro-2,6-naphthalenediylidene)bis[propanedinitrile], 2,2'-[4,8-Bis[2,4-bis(trifluoromethyl)phenyl]benzo[1,2-d:4,5-d']bisoxazole-2,6-diylidene]bis[propanedinitrile], from the class of metal complexes, in particular cerium(IV) diketonates and derivatives or from the class of benzobisoxazole and derivatives such as 2,2'-[4,8-Bis[2,4-bis(trifluoromethyl)phenyl]benzo[1,2-d:4,5-d']bisoxazole-2,6-diylidene]bis[propanedinitrile].

In addition, there might be further organic layers 4 such as a first hole transport layer 9.1, a second hole transport layer 9.2, a first electron transport layer 10.1, a second electron transport layer 10.2, and an electron injection layer 7. In addition, there might be a substrate 8.

The first hole transport layer 9.1 is arranged between the blue phosphorescent emissive layer 5 and the deep-HOMO p-doped semiconductor layer 6. The second hole transport layer 9.2 is arranged between the second emissive layer 15 and the p-type charge generation layer 16. The first hole transport layer 9.1 can be an intrinsic layer and the second hole transport layer 9.2 can be an intrinsic layer. The first electron transport layer 10.1 is arranged between the blue phosphorescent emissive layer 5 and the n-type charge generation layer 14. The second electron transport layer 10.2 is arranged between the second emissive layer 15 and the electron injection layer 7.

The thickness and the material of the corresponding layers of the first unit and the second unit can be identical or different. For example, the material and the thickness of the first hole transport layer 9.1 and of the second hole transport layer 9.2 may be identical or different.

### EXAMPLES

The following examples illustrate the invention without limiting it in any way.

### Synthesis

### SYNTHESIS OF D1:

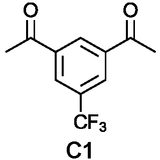

3,5-Dibromobenzotrifluoride (2.00 g, 6.6 mmol), butyl vinyl ether (3.95 g, 39.5 mmol), palladium(II) acetate (118 mg, 0.5 mmol), 1,3-bis(diphenylphosphino)propane (582 mg, 1.05 mmol) and triethylamine (3.33 g, 32.9 mmol) were dissolved in isopropanol (13 mL) in a microwave vial. Argon was bubbled through the resulting solution for 5 minutes and the vial was sealed. The reaction mixture was heated to 115°C for 4 days. After cooling the mixture to room temperature, 3 M aqueous HCl (30 mL) was added and stirring was continued for 30 minutes. The resulting mixture was extracted with CH₂Cl₂ (3 x 30 mL) and the combined organic phases were dried over Na₂SO₄. After evaporation of solvents, the crude reaction mixture was filtered over a plug of silica (petrol ether to petrol ether/methyl-t-butylether = 10:1 to petrol ether/methyl-t-butylether = 7:3). Evaporation of solvents yielded acetophenone **C1** (950 mg, 63%) as a white solid.
APCI-MS: m/z = 231.2 [M+H]⁺

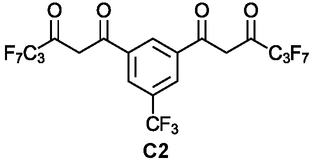

Sodium methoxide (563 mg, 10.4 mmol) was added in one portion to a solution of ethyl heptafluorobutanoate (2.52 g, 10.4 mmol) in anhydrous tetrahydrofurane (THF) (10 mL) at room temperature. After the resulting suspension was stirred for 10 minutes, acetophenone C1 (1.00 g, 4.34 mmol) was added. After 17 hours the reaction mixture was poured on ice water (100 mL) and acidified with 3 M aqueous HCl (50 mL). The resulting precipitate was collected after filtration. The filtrate was extracted with methyl-t-butylether (MTBE or TBME) (3 x 50 mL). The combined organic phases were dried over Na₂SO₄ and the solvents were removed under reduced pressure. The combined products were dried under vacuum yielding tetraketone **C2** (2.70 g, 99%) as an off-white solid.
APCI-MS: m/z = 623.3 [M+H]⁺

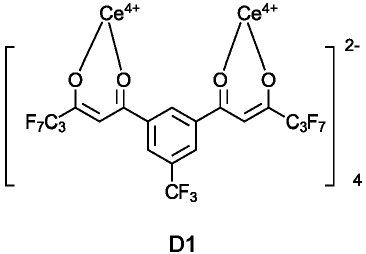

Sodium hydride (84 mg, 60% dispersion in mineral oil, 2.1 mmol) was added in one portion to a solution of tetraketone C2 (651 mg, 1.05 mmol) in acetonitrile (20 mL). The resulting mixture was stirred for ten minutes until gas evolution ceased. Subsequently, ceric ammonium nitrate (287 mg, 0.52 mmol) was added in one portion and the resulting mixture was stirred for 30 minutes. The reaction mixture was filtered, and the precipitate was washed with water (30 mL) and CH₂Cl₂ (30 mL) yielding cerium complex D1 (628 mg, 87%) as a red-brown solid.

¹H-NMR (295 K, 80 MHz, d₆-acetone): δ (in ppm) = 8.93 (s, 4H), 8.40 (m, 8H), 6.62 (s, 8H). ¹⁹F-NMR (295 K, 76 MHz, d₆-acetone): δ (in ppm) = -61.64, -79.90 (t, J = 9.0 Hz), -118.40 (d, J = 9.0 Hz), -125.31 - -125.50 (m).

### SYNTHESIS OF D2:

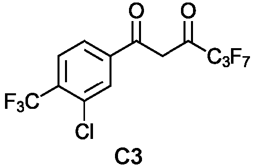

NaOMe (1.68 g, 30.5 mmol) was suspended in methyl-t-butylether (80 ml) containing ethyl heptafluorobutyrate (7.4 g, 30.5 mmol) and cooled to 0°C. 1-(3-chloro-4-(trifluoromethyl)phenyl)ethan-1-one (5.22 g, 23.5 mmol) in methyl-t-butylether (25 ml) were added dropwise over 30 min. The mixture was warmed to room temperature and stirred for 2 hours. HCl (1M, 30 ml) was added. The organic phase was separated and washed with saturated NaCl. The organic phase was dried over MgSO₄, filtered and the volatiles removed in vacuo. The crude diketone was distilled. The product was obtained as colorless liquid (7.88 g, 80%).

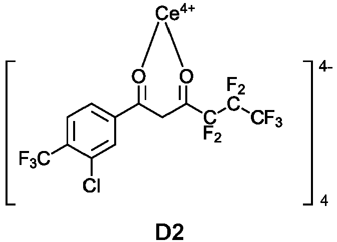

Dione C3 (7.88 g, 18.85 mmol) was added to a cooled suspension of NaH (0.455 g, 18.9 mmol) in methyl-t-butylether (50 ml) at 0°C. After the gas evolution ceased the volatiles were removed in vacuo and the residue was dissolved in acetonitrile (20 ml). Cerium ammonium nitrate (2.58 g, 4.71 mmol) was added and the suspension was stirred for 30 min. The volatiles were removed and the residue dissolved in diethyl ether (100 ml), washed with water and saturated NaCl. The organic phase was dried (MgSO₄), filtered, and and rotated off. The red material was recrystallized from hexane affording complex D2 (5.56g, 65%).

### SYNTHESIS OF D3:

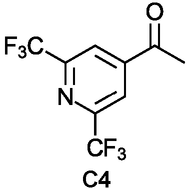

iPrMgCl (2M in tetrahydrofurane) was added dropwise to a solution of 4-bromo-2,6-bis(trifluoromethyl)pyridine (15 g, 51 mmol) in 100 ml dry tetrahydrofurane at 0°C. After addition, the mixture was stirred for 1 hour and was then added dropwise to neat acetic anhydride (25.5 g, 250 mmol) at 0°C. The reaction was stirred for 30 minutes while it reached room temperature. Water (50 ml) was added and the reaction mixture was heated up to 60°C for 30 minutes. After cooling down, diethyl was added (50ml) and the phases were separated. The organic phase was washed with water, brine, dried over sodium sulfate and rotated off. The crude oil was purified by vacuum distillation yielding a colorless liquid, acetophenone C4 (8.1g, 31.5 mmol, 62%).

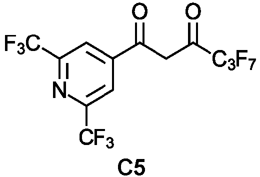

A solution of acetophenone **C4** (5.6 g, 21.8 mmol) in 15 ml methyl-t-butylether was added to a mixture of ethyl heptafluorobutyrate (6.9 g, 28.3 mmol) and MeONa (1.55g, 28.3 mmol) in methyl-t-butylether (40 ml) at 0°C and stirred for 2 hours. HCl (1M, 30 ml) was added and the two phases were separated. The organic phase was washed with brine, dried over MgSO₄ and rotated off. The red oily diketone was purified by vacuum distillation yielding **C5** as a pale yellow oil (6.89 g, 15.2 mmol, 70%)

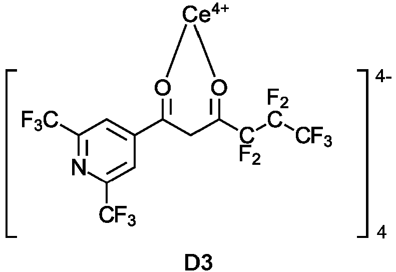

Dione **C5** (4.68 g, 10.3 mmol) was dissolved in methyl-t-butylether (40 ml), cooled to 0°C and NaH (0.41 g, 10.3 mmol) was added. After the gas evolution ceased the volatiles were removed in vacuo. The residue was dissolved in acetonitrile (40 ml) and cerium ammonium nitrate (1.41 g, 2.57 mmol) was added. After 90 minutes, the solvent was evaporated. The crude solid was rinsed with hexane (10 ml) and then extracted with methyl-t-butylether (40ml) and filtered. The solution was rotated off. It was then redissolved in 10 ml methyl-t-butylether and sonicated while 100 ml DCM (dichloromethane) were added. A red crystalline material formed which was filtered and dried in vacuo yielding the title product **D3** as red crystalline solid (2.47 g, 49%). APCI-MS: 1948 [M+].

### DFT calculations

Calculations of electronic structures including LUMO values were carried out employing density functional theory, using the ORCA 5.0.4 program package (FAccTs GmbH, Rolandstraße 67, 50677 Köln, Germany) and the B3LYP functional, along with the def2-TZVP basis set in the gas phase.

### Sample preparation and measurements

To determine the evaporation temperature, 15 mg of the material was filled in an aluminum oxide crucible of a point source and heated in a vacuum chamber (base pressure <5 × 10 -7 mbar) at 5 K/min until an evaporation rate of 0.3 Å/s is reached. The evaporation rate is monitored with a quartz crystal microbalance (QCM). The rate is kept constant for 10 min by controlling the heating and the evaporation temperature is determined by measuring the temperature at the bottom of the crucible with a thermocouple. To achieve stable evaporation rates and to avoid cross contamination in mass production of organic electronic devices, such as OLEDs, it is advantageous to use materials with a high evaporation temperature of at least above 120°C. Advantageously, evaporation temperatures above 120°C reduce the risk of cross contamination during thermal evaporation in vacuum and are accordingly suitable for mass production.

To verify the advantageous properties of organic light-emitting diodes (OLEDs) with the deep-LUMO p-dopants D1, D2 and D3 and comprising deep-HOMO p-doped semiconductor layers with HOMO levels deeper than -5.00 eV and with an emissive layer comprising a blue phosphorescent emitter material, the OLED structures were prepared as follows.

For Example 1, a glass substrate with a pre-patterned 125 nm ITO anode was initially ultrasonically cleaned with dimethyl sulfoxide for 20 minutes, followed by a 5-minute rinse with Di-water. Subsequently, the substrate underwent ultrasonic cleaning with Di-water and then ethanol for 10 minutes. Afterward, it was rinsed again with Di-water and dried by spin-coating at 1500 rpm in a nitrogen stream. Finally, an oxygen plasma treatment was applied to prepare the anode surface.

Then, a 10 nm deep-HOMO p-doped semiconductor layer in the form of a hole-injection layer (HIL) was formed by vacuum depositing the deep-HOMO hole transport material BPAPF (9,9-Bis[4-(N,N-bis-biphenyl-4-yl-amino)phenyl]-9H-fluorene) doped with 5 vol% of a deep-LUMO p-dopant D1 on top of an anode in the form of an indium tin oxide (ITO) electrode. Next, a 100 nm hole-transport layer (HTL) was formed by vacuum depositing BPAPF on top of the HIL. Then, a 10 nm electron-blocking layer (EBL) was deposited on the HTL using 1,3-Bis(N-carbazolyl)benzene (m-CP).

Afterwards, a blue phosphorescent emissive layer (EML) consisting of 1,3-Bis(N-carbazolyl)benzene (m-CP), 4,6-Bis(3,5-di(pyridin-3-yl)phenyl)-2-methylpyrimidine (B3PyMPM) and phosphorescent blue emitter dopant Bis[2-(4,6-difluorophenyl)pyridinato-C2,N](4-methylpicolinato)iridium(III) was vacuum deposited with a ratio of 45:45:10 in vol% and with a thickness of 25 nm.

Then, a 10 nm hole-blocking layer (HBL) was deposited on the EML using 4,6-Bis(3,5-di(pyridin-3-yl)phenyl)-2-methylpyrimidine (B3PyMPM). Subsequently, a 25 nm electron transport layer (ETL) was formed on the HBL by co-evaporating 4,7-Diphenyl-1,10-phenanthroline (BPhen) and Cs in a 1:1 ratio. Finally, a 100 nm layer of Al was deposited on the ETL to serve as the cathode layer.

The OLED structure was shielded from ambient conditions by an encapsulating glass lid that creates a cavity. This cavity holds a getter material, providing additional protection to enhance the integrity and lifespan of the OLED structure.

The OLED structure of Example 2 was prepared in the same way as Example 1 but with a deep-HOMO p-doped semiconductor layer in form of a HIL comprising 5 vol% of the deep-LUMO p-dopant D2 instead of D1.

The OLED structure of Example 3 was prepared in the same way as Example 1 but with a deep-HOMO p-doped semiconductor layer in form of a HIL that was prepared by co-depositing 4,4',4-Tris(carbazol-9-yl)triphenylamine (TCTA) and D1 with 5 vol% concentration of D1 and the HTL was prepared by depositing TCTA.

The OLED structure of Example 4 was prepared in the same way as Example 1 but with a deep-HOMO p-doped semiconductor layer in form of a HIL that was prepared by co-depositing TCTA and D3 with 5 vol% concentration of D1 and the HTL was prepared by depositing TCTA.

The OLED structure of Comparative Example 1 was fabricated by vacuum depositing 1,4,5,8,9,11-Hexaazatriphenylenehexacarbonitrile (HAT-CN) as the HIL on top of the ITO anode. Then, the HTL was formed on the HIL by depositing N-([1,1'-Biphenyl]-4-yl)-9,9-dimethyl-N-(4-(9-phenyl-9H-carbazol-3-yl)phenyl)-9H-fluoren-2-amine (BCFN). Following HTL, the layers were fabricated in the same way as Example 1.

The OLED structure of Comparative Example 2 was fabricated in the same way as Comparative Example 1, but instead of BCFN, BPAPF was used in the HTL.

The OLED structure of Comparative Example 3 was fabricated in the same way as Comparative Example 1, but instead of BCFN, TCTA was used in the HTL.

The OLED structure of Comparative Example 4 was fabricated in the same way as Example 1, but the HIL was prepared by co-depositing BCFN and D1 with 5 vol% concentration of D1 and the HTL was prepared by depositing BCFN.

The OLED structure of Comparative Example 5 was fabricated in the same way as Example 1, but the HIL was prepared by co-depositing BCFN and D2 with 5 vol% concentration of D2 and the HTL was prepared by depositing BCFN.

The electro-optical performance parameters of the OLEDs, including operating voltage, and power efficiency at 10 mA/cm², were evaluated at room temperature. The operating voltage was derived from the current-voltage characteristics which were recorded using a Keithley 2400 source-measure device, applying voltage in 0.1 V increments within the range of -2 V to 8 V. To determine the power efficiency, the OLEDs were measured inside an integrating sphere lined with a highly reflective white material, ensuring that all light emitted from the OLED's hemisphere was collected by a detector. Measurements were performed as previously described, with intensity recorded using an OceanOptics USB 4000 spectrometer and a photodiode. The determined parameters are provided in Table 1.

### Technical effect

### Evaporation temperature

**Table 1**

| p-Dopant | T_evap |
|---|---|
| D1 | 227°C |
| D2 | 125°C |
| D3 | 132°C |

As can be seen from Table 1 compounds D1, D2, and D3 show evaporation temperatures above 120°C. Accordingly, these materials can advantageously be used for mass production using thermal evaporation.

### OLED performance

**Table 2**

| | HTM in HIL and HTL) | HOMO of the hole transport material | p-Dopant in the HIL | Voltage [V] at 10 mA/cm² | **Power efficiency [lm/W] at 10 mA/ cm²** |
|---|---|---|---|---|---|
| Comparative Example 1 | BCFN | -4.90 | HAT-CN | 4.6 | 12.8 |
| Comparative Example 2 | BPAPF | -5.08 | HAT-CN | 7.6 | 9.1 |
| Comparative Example 3 | TCTA | -5.37 | HAT-CN | >8 | Not reached |
| Comparative Example 4 | BCFN | -4.90 | D1 | 4.5 | 13.1 |
| Comparative Example 5 | BCFN | -4.90 | D2 | 4.5 | 13.5 |
| Example 1 | BPAPF | -5.08 | D1 | 4.1 | 16.4 |
| Example 2 | BPAPF | -5.08 | D2 | 4.1 | 15.9 |
| Example 3 | TCTA | -5.37 | D1 | 4.4 | 18.4 |
| Example 4 | TCTA | -5.37 | D3 | 4.1 | 20.7 |

In comparative example 1 the HTL consists of a shallow-HOMO hole-transport material and the HIL comprises an organic shallow-LUMO p-dopant, i.e. the HOMO of the hole-transport material is not in the defined range according to the invention, but shallower, and the LUMO of the p-dopant is not in the defined range according to the invention, but shallower. The operating voltage at 10 mA/cm² is 4.6 V and the power efficiency is 12.8 Im/W.

In comparative examples 2 and 3 a deep-HOMO hole-transport material is used in the HTL and the p-dopant is the same as in comparative example 1, i.e. the HOMO of the hole-transport material is deeper than of the hole transport material applied in comparative example 1, but the LUMO of the p-dopant is not in the defined range according to the invention, but shallower. The voltage increases significantly and the power efficiency is reduced.

In comparative examples 4 and 5 the shallow-HOMO hole-transport material is combined with deep-LUMO p-dopants comprising Ce(IV), i.e. the HOMO of the hole-transport material is not in the defined range according to the invention, but shallower, and the LUMO of the p-dopant is deeper than the LUMO of the p-dopant applied in comparative examples 1 and 2. There is only a very small improvement in voltage and power efficiency.

The organic light-emitting diodes of examples 1 to 4 comprise a deep-HOMO p-doped semiconductor layer according to the invention. The operating voltage is advantageously reduced and the power efficiency is significantly enhanced. This result is only attained by the combination of a deep-HOMO hole-transport material according to the invention and a deep-LUMO p-dopant comprising Ce(IV) according to the invention in the HIL.

1,3-Bis(N-carbazolyl)benzene (m-CP) has a HOMO of -5.69 eV determined by DFT calculations. Accordingly, the HOMO level of the used emitter host material m-CP is deeper than HOMO level of the applied hole transport material (HTM1) for the Examples 1 to 4, but not deeper than the HOMO (HTM1) - 1 eV.

In summary, organic light-emitting diodes according to the invention show improved operating voltage and power efficiency. A high power efficiency is important to reduce power consumption of lighting and display applications and to prolong battery life in mobile applications. The p-dopants according to the invention have favorable properties for mass production with high yield.

## Claims

1. **An organic light-emitting diode (1)** comprising:
- an anode layer (2), a cathode layer (3), and several organic layers (4) arranged between the anode layer (2) and the cathode layer (3), including at least a blue phosphorescent emissive layer (5) and at least one deep-HOMO p-doped semiconductor layer (6);
- Wherein the blue phosphorescent emissive layer (5) comprises at least one blue phosphorescent emitter material and an emitter host material
- wherein the deep HOMO p-doped semiconductor layer (6) is arranged between the anode layer (2) and the blue phosphorescent emissive layer (5);
wherein the deep HOMO p-doped semiconductor layer (6) comprises a deep-HOMO hole transport material and a deep-LUMO p-dopant,
wherein the HOMO of the deep-HOMO hole transport material is in the range between -5.0 eV and -6.0 eV when determined by DFT calculations, and
wherein the deep-LUMO p-dopant is an organometallic complex comprising Ce(IV) and wherein the LUMO of the deep LUMO p-dopant is in the range between -4.8 eV and -5.8 eV when determined by DFT calculations.

2. The organic light-emitting diode (1) according to claim 1, wherein the LUMO of the deep LUMO p-dopant is in the range between -4.9 eV and -5.6 eV, more preferably - 5.0 eV and -5.6 eV when determined by DFT calculations or the LUMO of the deep LUMO p-dopant is at least as deep as the LUMO of Tetrakis[1-[3,5-bis(trifluoromethyl)phenyl]-4,4,4-trifluoro-1,3-butanedionato-κO1,κO3]cerium if measured with the same method.

3. The organic light-emitting diode (1) according to claim 1 or 2, wherein the HOMO of the deep-HOMO hole transport material is preferably at least as deep as N,N'-((9H-fluorene-9,9-diyl)bis(4,1-phenylene))bis(N-([1,1'-biphenyl]-4-yl)-[1,1'-biphenyl]-4-amine) if measured with the same method or
wherein the HOMO of the deep-HOMO hole transport material is in the range between -5.05 eV and -6.0 eV when determined by DFT calculations.

4. The organic light-emitting diode (1) according to one of the claims 1 to 3, wherein the blue phosphorescent emissive layer (5) comprises at least one deep-HOMO emitter host material, wherein the HOMO level of the deep-HOMO emitter host material (EML-host) of the blue phosphorescent emissive layer (5) and the HOMO level of the deep HOMO hole transport material (HTM1) fulfill the following equation: $- 1.0 eV < HOMO \left(EML-host\right) - HOMO \left(HTM1\right) < 0.0 eV ,$ when determined by DFT calculations.

5. The organic light emitting diode (1) according to one of the claims 1 to 3, wherein at least one of the organic layers (4) is an undoped hole-transport material layer which is positioned between the deep-HOMO p-doped semiconductor layer (6) and the blue phosphorescent emissive layer (5), and wherein the HOMO levels of the undoped hole-transport material layer (HTM2), of the deep-HOMO hole transport material (HTM1), and of the emitter host material (EML-host) of the blue phosphorescent emissive layer (5) fulfill the following equation: $HOMO \left(HTM1\right) \geq HOMO \left(HTM2\right) \geq HOMO \left(EML-host\right) .$

6. The organic light-emitting diode (1) according to one of the claims 1 to 5,
wherein the deep LUMO p-dopant is a compound of the general formula (I)
**[Ce⁴⁺][(L_{I})₄]⁴⁻** **(I),**
wherein L_{I} is independently of each other a ligand with at least five carbon atoms.

7. The organic light-emitting diode (1) according to one of the claims 1 to 5,
wherein the deep LUMO **p-dopant** is a compound of the general formula (II)
**[Ce⁴⁺]₂[(L_{II})ₙ]⁸⁻** **(II),**
wherein n is an integer from 1 to 8,
wherein L_{II} is independently of each other a ligand with at least five carbon atoms.

8. The organic light-emitting diode (1) according to claim 6, wherein L_{IA}, L_{IB}, L_{IC}, and L_{ID} have the same meaning.

9. The organic light-emitting diode (1) according to claim 7, wherein L_{IIA}, L_{IIB}, L_{IIC}, and L_{IID} have the same meaning.

10. The organic light-emitting diode (1) according to claim 7 or 9, wherein n is 4 and L_{II} is a bis-bidentate ligand, comprising at least one compound of the formula (Il.a):
[Ce⁴⁺]₂L_{IIA}²⁻L_{IIB}²⁻L_{IIC}²⁻L_{IID}²⁻ (II.a)
wherein L_{IIA;} L_{IIB;} L_{IIC}; and L_{IID} have the same or different meanings,
wherein
L_{IIA;} L_{IIB;} L_{IIC}; and L_{IID} are each a bis-bidentate ligand independently selected from formula (Il.b) 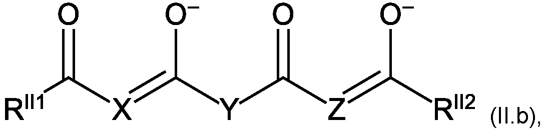 wherein
**X** is selected from C-H, C-CF₃ and C-R^{II3};
**Z** is selected from C-H, C-CF₃ and C-R^{II4};
**R^{II1}, R^{II2}, R^{II3} and R^{II4}** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl or C₁-C₆-haloalkyl,
wherein aryl and heteroaryl are unsubstituted or substituted by 1, 2, 3, 4 or 5 identical or different radicals R^{II5};
wherein R^{II5} is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein
**Y** is selected from C₆-C₁₄-arylene, 4- to 14-membered heteroarylene having 1, 2 or 3 identical or different heteroatoms or heteroatom-containing groups as ring members, selected from N, O, S, SO and SO₂, C₁-C₁₀-alkylene, C₃-C₆-cycloalkylene, C₃-C₆-cycloalkenylene, C₁-C₁₀-haloalkylene, C₁-C₁₀-haloalkylarylene, S, S-O, O, P-**R^{II6}**, P-O-R^{II7}, Si-(R^{II8})₂, B-R^{II9} and N-R^{II10};
wherein arylene and heteroarylene are unsubstituted or substituted by 1, 2, 3, 4 or 5 identical or different radicals R^{II5};
wherein R^{II5} is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl
wherein **R^{II6}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein **R^{II7}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein **R^{II8}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkylene;
wherein **R^{II9}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein **R^{II10}** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.

11. The organic light-emitting diode (1) according to claim 6 or 8, wherein the deep LUMO p-dopant is a compound according to formula (I)
Ce⁴⁺(L_{IA}L_{IB}L_{IC}L_{ID})⁴⁻ (I.a)
or the mixtures thereof, wherein L_{IA;} L_{IB;} L_{IC;} and L_{ID} are independently from each other selected from a bidentate ligand having the general formula (I.b) 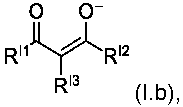 wherein
R^{I1}, R^{I2} independently from each other represent CN, C₁-C₆-alkyl, C₁-C₆-haloalkyl, C₁-C₆-alkoxy, C₁-C₆-haloalkoxy, C₁-C₆-alkylsulfanyl, C₁-C₆-haloalkylsulfanyl, NR^{I4a}R^{I4b}, C₆-C₁₄-aryl or hetaryl having 4 to 13 carbon atoms, wherein hetaryl has 1, 2 or 3 identical or different heteroatoms or heteroatom-containing groups as ring members, selected from N, NR^{I7}, O, S, SO and SO₂, wherein aryl and hetaryl are unsubstituted or substituted by 1, 2, 3, 4 or 5 identical or different radicals R^{I8};
R^{I3} represents hydrogen, CN, nitro, halogen, C₁-C₆-alkyl, C₁-C₆-haloalkyl, C₁-C₆-alkoxy, C₁-C₆-haloalkoxy, C₁-C₆-alkylsulfanyl, C₁-C₆-haloalkylsulfanyl, NR^{I4a}R^{I4b}, C₆-C₁₄-aryl or hetaryl having 4 to 13 carbon atoms, wherein hetaryl has 1, 2 or 3 identical or different heteroatoms or heteroatom-containing groups as ring members, selected from N, NR^{I7}, O, S, SO and SO₂, wherein aryl and hetaryl are unsubstituted or substituted by 1, 2, 3, 4 or 5 identical or different radicals R^{I5};
R^{I4a}R^{I4b} independently from each other represent hydrogen, C₁-C₆-alkyl or C₆-C₁₄-aryl, wherein aryl is unsubstituted or substituted by 1, 2, 3, 4 or 5 identical or different radicals R^{I5};
R^{I5} represents CN, halogen, C₁-C₄-alkyl or C₁-C₄-haloalkyl;
R^{I6} represents hydrogen, C₁-C₆-alkyl, C₁-C₆-haloalkyl, C₆-C₁₄-aryl or hetaryl having 4 to 13 carbon atoms, wherein hetaryl has 1, 2 or 3 identical or different heteroatoms or heteroatom-containing groups as ring members, selected from N, NR⁷, O, S, SO and SO₂, wherein aryl and hetaryl are unsubstituted or substituted by 1, 2, 3, 4 or 5 identical or different radicals R^{I5};
R^{I7} represents hydrogen, C₁-C₆-alkyl, C₁-C₆-haloalkyl or C₆-C₁₄-aryl, wherein aryl is unsubstituted or substituted by 1, 2, 3, 4 or 5 identical or different radicals R^{I5};
R^{I8} represents CN, halogen, C₁-C₄-alkyl, C₁-C₄-haloalkyl or C₆-C₁₄-aryl, which is unsubstituted or substituted by 1, 2 or 3 identical or different radicals selected from C₁-C₄-alkyl and C₁-C₄-haloalkyl.

12. The organic light-emitting diode (1) according to claim 11, wherein for R^{I1}, R^{I2}, R^{I3} that are present, the corresponding σ^{x} is >0.05, with being the Hammett constant of R^{x}; whereby, with σ^{total}>0.5, with σ^{total}= σ¹+ σ²+σ³ and σ^{x} being the Hammett constant of R^{Ix}.

13. The organic light-emitting diode (1) according to one of the claims 1 to 12, wherein the **blue phosphorescent emitter material** is a transition metal complex.

14. **A method to produce an organic light emitting diode (1)** according to one of the claims 1 to 13, comprising at least one of the following steps:
(a) Simultaneous evaporation of the hole transport material and the deep LUMO p-dopant,
(b) Evaporation of a pre-mixed material containing the hole transport material and the deep LUMO p-dopant from one single source,
(c) Sequential deposition of the hole transport material and the deep LUMO p-dopant,
(d) Doping of a hole transport material layer by a solution of at least one deep LUMO p-dopant followed by evaporation of the solvent by thermal treatment,
(e) Surface doping of a layer of a deep-HOMO hole transport material by a layer of at least one deep-LUMO p-dopant applied to one or both surfaces of the layer of a deep-HOMO hole transport material,
(f) Preparing a solution of a deep-HOMO hole transport material and at least one deep-LUMO p-dopant and forming a film from the solution.
